# EUROPÄISCHE PATENTSCHRIFT

(11) **EP 1 723 203 B1**
(45) Veröffentlichungstag und Bekanntmachung des Hinweises auf die Patenterteilung: **20.04.2011**
(21) Anmeldenummer: 05715435.3
(22) Anmeldetag: 22.02.2005
(51) Int. Cl.: C09B 67/22, G03F 7/00, G03G 9/09, C09D 11/00

(54) **VIOLETTES FARBMITTEL FÜR COLOR FILTER, INK JET TINTEN, ELEKTROPHOTOGAPHISCHE TONER UND ENTWICKLER UND E-INKS**
VIOLET COLORANT FOR COLOUR FILTERS, INKS FOR INK-JET, ELECTROPHOTOGRAPHIC TONERS AND DEVELOPERS AND E-INKS
COLORANT VIOLET POUR FILTRES COLORES, ENCRES POUR JETS D'ENCRE, TONERS ELECTROPHOTOGRAPHIQUES ET REVELATEURS ET ENCRES ELECTRONIQUES

(30) Priorität: 03.03.2004 DE 102004010282
(43) Veröffentlichungstag der Anmeldung: 22.11.2006
(73) Patentinhaber: Clariant Produkte (Deutschland) GmbH, 65929 Frankfurt am Main (DE)
(72) Erfinder: HECKMANN, Heino, 65835 Liederbach (DE); MACHOLDT, Hans-Tobias, 64297 Darmstadt-Eberstadt (DE); VENERA, Magali, 65779 Kelkheim (DE)
(74) Vertreter: Hütter, Klaus
(86) Internationale Anmeldenummer: PCT/EP2005/001802
(87) Internationale Veröffentlichungsnummer: WO 2005/085367

(56) Entgegenhaltungen:
- EP-A- 0 321 919
- EP-A- 0 504 923
- EP-A- 0 604 895
- EP-A- 0 659 842
- WO-A-01/04215
- GB-A- 2 275 477
- US-A- 4 451 398
- US-A- 5 420 187
- US-B1- 6 284 432
- DATABASE WPI Section Ch, Week 199735 Derwent Publications Ltd., London, GB; Class A60, AN 1997-381405 XP002335382 & JP 09 165528 A (DAINIPPON INK & CHEM INC) 24. Juni 1997 (1997-06-24)
- DATABASE WPI Section Ch, Week 199731 Derwent Publications Ltd., London, GB; Class E24, AN 1997-337197 XP002329687 -& JP 09 137075 A (NIPPON KAYAKU KK) 27. Mai 1997 (1997-05-27)
- DATABASE WPI Section Ch, Week 199021 Derwent Publications Ltd., London, GB; Class E24, AN 1990-158633 XP002335383 -& JP 01 247468 A (TOYO INK MFG CO) 3. Oktober 1989 (1989-10-03)

## Beschreibung

Die vorliegende Erfindung betrifft den Einsatz von Pigmentzubereitungen auf Basis von Dioxazinen (Pigment Violett 23) und pigmentspezifischen Dispergatoren, bevorzugt mit basischen Gruppen substituiertes Pigment Violett 23, in Color Filtern, Ink Jet Tinten, elektrophotographischen Tonern und Entwicklern, und e-inks.

Bei Color Filtern (Farbfilter) wird mittels Durchlicht von roten, grünen und blauen Bildpunkten ein Vollfarbbild erzeugt. Neben den "transmissive" (or "non-emissive") (= Durchlicht) Color Filtern gibt es auch "reflective" Color Filter, die dann gegebenenfalls auch mit gelb, cyan und magenta Bildpunkten arbeiten können. Bei den Color Filtern unterscheidet man zwischen AM-(active matrix) und PM-(passive matrix) LCD (liquid crystal display) Color Filtern, wobei den TFT (thin film transistor)-LCD Color Filtern eine besondere Bedeutung zukommt.

Darüber hinaus können Color Filter auch bei MEMS (DMD) (= Micro-Electro-Mechanical Systems, Digital Micro Mirror Device), bei e-paper sowie weiteren geeigneten Display Technologien Einsatz finden.

Color Filter Displays finden in den unterschiedlichsten electro-optischen Systemen Anwendung, wie z.B. in Bildschirmen von Desk-Top Monitoren, in Computerbildschirmen, Bildschirmen von tragbaren Computern (Laptops, portable computers), PDA (Personal Digital Assistants) sowie in Mobiltelefon-, Videokamera-, GPS- (global positioning systems) und sonstigen Monitoren, sowie generell in Flüssigkristall- und Charge-Coupled-Devices, plasma displays oder in electroluminiscenten und anderen Displays. Letztgenannte können z.B. active (twisted nematic) oder passive (supertwisted nematic) ferroelektrische Displays sein oder z.B. Licht emittierende Dioden.

Zudem finden Farbfilter Einsatz in Flat Panel Displays (Flachbildschirmen), die zunehmend die herkömmlichen Kathodenstrahl-Fernsehbildschirme ersetzen, oder die generell als Anzeigetafel in beliebiger Größe für unbewegte und bewegte Information genutzt werden können.

Ein typischer LCD-Color-Filter Aufbau kann wie folgt schematisch beschrieben werden: Zwischen zwei Glasplatten befindet sich eine dünne Schicht mit Flüssigkristallen. Die obere Glasplatte hat neben einer Reihe von weiteren funktionalen Komponenten auf der äußeren Oberfläche die entsprechenden Bildpunkte, z.B. Rot, Grün, Blau ( R,G,B). Diese Bildpunkte sind für einen besseren Kontrast schwarz umrandet, nach außen sind die R, G, B -Bildpunkte durch eine geeignete Schutzschicht gegen Umwelteinflüsse, wie Kratzer, geschützt. Die untere Glasplatte enthält noch weitere funktionale Komponenten wie z.B. ITO (Indium Tin Oxide) und TFT (Thin Film Transistors), die unter anderem zum Ansteuern der einzelnen Bildpunkte dienen.

Wird nun durch die untere Glasplatte geeignetes Licht (z.B. linear polarisiertes Licht einer bestimmten Wellenlänge) geschickt, so kann nun der Flüssigkristall durch elektronisches Ansteuern auf "hell" oder "dunkel" gestellt werden (oder auf jede beliebige Zwischenstufe).

Dementsprechend werden die Color Filter -Bildpunkte mit Licht versorgt und für das menschliche Auge ergibt sich ein entsprechendes auf R, G, B aufbauendes, farbiges, bewegtes oder unbewegtes Bild.

Ganz besondere Anforderungen werden bei den Color Filter-Materialien an die eingesetzten Farbmittel gestellt.

Als wichtigste technische Parameter, die erfüllt sein müssen, lassen sich nennen:
- hohe Thermostabilität: während des Herstellvorganges eines Color Filters werden die einzelnen aufgetragenen Schichten erhitzt, so dass die Pigmentzubereitung für bis zu 1 Stunde Temperaturen bis zu 300°C aushalten muss;
- gute Dispergierbarkeit in Color Filter Systemen;
- steile und schmale Absorptionsbanden der jeweils aufgebrachten Color Filter Schicht;
- hoher Kontrast;
- eine gute und stabile Viskosität im Color Filter Medium: Eine zu hohe Viskosität verhindert die gleichmäßige Verteilung der Flüssigkeit auf dem Glassubstrat und beeinträchtigt dadurch die Qualität des Bildes;
- ökotoxikologische Unbedenklichkeit beim Verarbeiten;
- nicht flokkulierendes Verhalten
- eine möglichst glatte (= nicht rauhe) Oberfläche der aufgebrachten (pigmentierten) Color Filter
- Säurebeständigkeit (für z.B. Etchingverfahren)
- Lösemittelechtheit.

In WO 01/04215 A2 wird ein Prozess zur Herstellung von Pigmenten offen gelegt, der eine Reibungsbeanspruchung eines Rohpigments, darunter bevorzugt P.V. 23, in Gegenwart größerer Mengen anorganischer Salze mit anschließender Knetung des so erhaltenen Produkts in Gegenwart organischer Flüssigkeiten vorsieht. Der Einsatz derartiger Pigmente in Color Filtern wird ebenfalls offen gelegt.

US 6 284 432 B1 beschreibt Farbmittel für Color Filter, die sich aus einem organischen Pigment sowie einem Sulfonat- und Sulfonamidgruppen enthaltenden Derivat eines organischen Pigments und einem Bindemittel zusammensetzen.

Die durch diese Methoden gewonnenen Farbmittel können jedoch die hohen Anforderungen, die die Anwendung in Color Filter-Materialien an die Farbmittel stellen, nicht immer ausreichend erfüllen. So ist beispielsweise die Dispergierbarkeit und das Flokkulationsverhalten der Farbmittel, die Rheologie daraus hergestellter Pigmentpräparationen, sowie die Homogenität und Glattheit daraus hergestellter Schichten noch nicht ausreichend. Weiterhin sind optische Parameter, wie die Transmission, Steilheit der Absorptionsflanken und der Kontrast (Beibehaltung der Polarisation) verbesserungswürdig.

Für den violetten Farbton und zum Abtönen von blauen Farbtönen sind Farbmittel auf Basis von C.I. Pigment Violet 23 wegen der Farbnuance von besonderem Interesse.

Derzeit am Markt befindliche Pigmente auf Basis von P.V. 23 haben jedoch Mängel bezüglich der Dispergierbarkeit in Color Filter Systemen, des Flokkulationsverhaltens, einer guten und stabilen Viskosität, der Oberflächenbeschaffenheit (z.B. Rauheit) des Color Filters sowie des (Bild) Kontrastes und können deswegen entweder gar nicht oder nur eingeschränkt eingesetzt werden.

Ziel der vorliegenden Erfindung war, ein Farbmittel mit violettem Farbton für den Einsatz in Color Filtern, Ink Jet Tinten, elektrophotographischen Tonern und Entwicklern und e-inks zur Verfügung zu stellen, das die voranstehend erläuterten Mängel überwindet.

Die Aufgabe wurde überraschenderweise durch eine Pigmentzubereitung, bestehend aus einer Kombination von P.V. 23 und Pigmentdispergatoren auf Basis von Dioxazinverbindungen, die bevorzugt mit basischen Gruppen substituiert sind, gelöst.

Gegenstand der vorliegenden Erfindung ist die Verwendung einer Pigmentzubereitung, gekennzeichnet durch einen Gehalt an
a) einer Dioxazinverbindung der Formel (I) als Basispigment 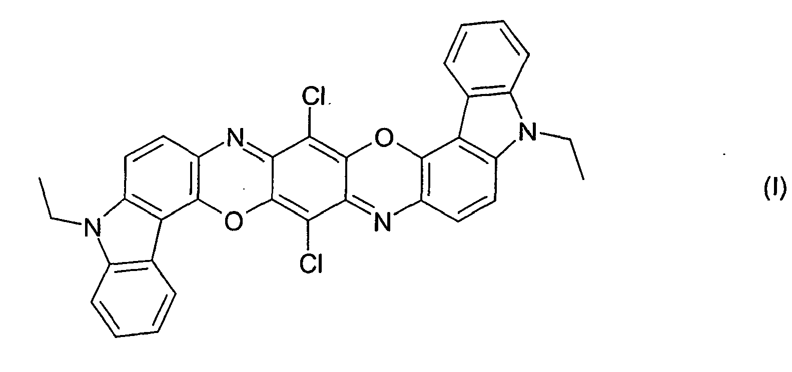 und
b) einer Dioxazinverbindung der allgemeinen Formel (II) als Pigmentdispergator

   Q-[Y-X]ₘ (II)

   worin
   Q für einen m-wertigen Rest des Basispigments der Formel (I) steht,
   Y eine brückenbildende Gruppierung aus der Reihe -(CR¹R²)ₓ- mit x gleich 1 bis 6, substituiertes oder unsubstituiertes Phenylen, insbesondere 1,4-Phenylen, -CO-, oder -NR³- oder eine sich ggf. wiederholende Kombination von mindestens zwei solcher Brückenglieder unterschiedlichen Typs bezeichnet, wobei R¹, R² und R³ unabhängig voneinander Wasserstoff oder C₁-C₄-Alkyl bedeuten,
   X den Rest eines über ein C-Atom an das Brückenglied Y gebundenen, aliphatischen oder aromatischen, fünf-, sechs- oder siebengliedrigen heterocyclischen Systems mit jeweils 1 bis 3 ringangehörigen, gleichen oder unterschiedlichen Heteroatomen aus der Reihe Stickstoff, Sauerstoff oder Schwefel darstellt, das ggf. noch einen benzokondensierten Ring aufweist und durch C₁-C₄-Alkyl, C₂-C₄-Alkenyl, C₁-C₃-Hydroxyalkyl oder Phenyl substituiert sein kann;
   oder einen über den Imidstickstoff an das Brückenglied Y gebundenen Phthalimido-Rest darstellt, der am benzoiden Ring bis maximal vierfach durch Chlor, Brom, Nitro, Carboxy, N-(C₁-C₅-Alkyl)-carbamoyl, N-Phenylcarbamoyl oder Benzoylamino substituiert sein kann;
   oder einen Rest -NR⁴R⁵ darstellt, in dem R⁴ und R⁵ unabhängig voneinander jeweils Wasserstoff, ggf. substituiertes C₁-C₂₀-Alkyl oder C₂-C₂₀-Alkenyl, C₅-C₆-Cycloalkyl, ggf. substituiertes Phenyl, Benzyl oder Naphthyl sind;
   oder in dem die Gruppe -NR⁴R⁵ ein aliphatisches oder aromatisches, fünf-, sechs- oder siebengliedriges heterocyclisches System mit jeweils 1 bis 3 ringangehörigen, gleichen oder unterschiedlichen Heteroatomen aus der Reihe Stickstoff, Sauerstoff oder Schwefel bildet, das ggf. noch einen benzokondensierten Ring aufweist und durch Hydroxy, Oxo, C₁-C₄-Alkyl, C₂-C₄-Alkenyl, C₁-C₃-Hydroxyalkyl oder Phenyl substituiert sein kann, und
   m einen Zahlenwert zwischen 1 und 4 angibt,
   als Farbmittel in Color Filtern, Ink Jet Tinten, elektrophotographischen Tonern und Entwicklern und electronic inks.

Im Falle, dass m > 1 ist, können die Gruppen (Y-X) gleich oder verschieden sein, vorzugsweise ist jedoch bei mehreren Resten (Y-X) deren Bedeutung jeweils identisch.

Unter "substituiertem" Phenyl, Phenylen oder Alkyl werden vorzugsweise 1 bis 5 Substituenten aus der Gruppe Wasserstoff, CI, Br, C₁-C₁₈-Alkyl, C₅-C₆-Cycloalkyl, Benzyl, C₆-C₁₀-Aryl, Pyridyl, Pyrryl, Thienyl, Imidazolyl, Oxazolyl, Thiazolyl, Pyrimidyl, C₁-C₁₈-Alkoxy, C₆-C₁₀-Aryloxy, C₁-C₁₈-Alkylthio, C₆-C₁₀-Arylthio, C₁-C₁₈-Alkylamino, C₆-C₁₀-Arylamino, Di(C₁-C₁₈-alkyl)-amino, C₁-C₁₈-Alkyl-C₆-C₁₀-arylamino, Di(C₆-C₁₀-aryl)-amino, SO₃H, C₁-C₁₈-Alkoxysulfonyl, C₁-C₁₈-Alkylsulfonyl und Di(C₁-C₁₈-alkyl)-aminosulfonyl verstanden.

Bevorzugt sind Pigmentdispergatoren der Formel (II), worin
Y die Bedeutung -(CH₂)ₚ-, -CO-NR³-(CH₂)ₚ-, -CH₂-NR³-CO-(CH₂)ₚ- oder -CH₂-NR³-CO-CH₂-NH-(CH₂)ₙ-, in denen R³ Wasserstoff oder C₁-C₄-Alkyl bedeutet, sowie n und p unabhängig voneinander jeweils Zahlenwerte von 1 bis 6 darstellen,
X den Rest eines über ein C-Atom an das Brückenglied Y gebundenes Furan, Thiophen, Pyrrol, Pyrazol, Thiazol, Oxazol, Triazol, Imidazol, Thionaphthen, Benzoxazol, Benzothiazol, Benzimidazol, Benzotriazol oder Indol;
oder einen Rest -NR⁴R⁵ darstellt, in dem R⁴ und R⁵ unabhängig voneinander jeweils Wasserstoff, ggf. substituiertes C₁-C₆-Alkyl oder C₂-C₆-Alkenyl, C₅-C₆-Cycloalkyl, ggf. substituiertes Phenyl, Benzyl oder Naphthyl sind;
oder in dem die Gruppe -NR⁴R⁵ ein Pyrrolinyl, Pyrrolidinyl, Piperidinyl, Morpholinyl, Homopiperidinyl oder Imidazolyl bedeutet, das ggf. noch einen benzokondensierten Ring aufweist und durch Hydroxy, Oxo, C₁-C₄-Alkyl, C₁-C₃-Hydroxyalkyl oder Phenyl substituiert sein kann und
m eine Zahl von 1 bis 3 ist.

Besonders bevorzugt sind Pigmentdispergatoren der Formel (II), worin
Y -(CH₂)₁₋₃-, -CO-NH-(CH₂)_{1.3}-, -CH₂-NH-CO-(CH₂)₁₋₃- oder -CH₂-NH-CO-CH₂-NH-(CH₂)₂₋₃-,
× über den Imidstickstoff oder die Positionen 4 oder 5 an das Brückenglied Y gebundenes Imidazolyl oder einen Rest -NR⁴R⁵ bezeichnet, wobei R⁴ und R⁵ Wasserstoff oder C₁-C₄-Alkyl darstellen, und
m eine Zahl von 1 bis 2,5 ist.
Ganz besonders bevorzugt im Sinne der vorliegenden Erfindung sind Pigmentdispergatoren der Formel (III) 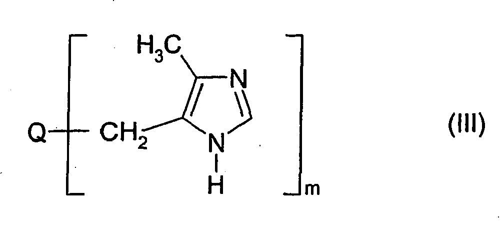 worin
Q die vorstehend genannte Bedeutung hat, und
m für einen Zahlenwert von 1 bis 4, bevorzugt 1 bis 3, besonders bevorzugt 1 bis 2,5, insbesondere 1 bis 2, steht.

Die erfindungsgemäß verwendeten Pigmentzubereitungen enthalten zweckmäßigerweise 0,5 bis 99 Gew.-%, bevorzugt 1 bis 75 Gew.-%, insbesondere 2,5 bis 50 Gew.-%, ganz besonders bevorzugt 5 bis 30 Gew.-%, an Pigmentdispergator der Formel (II) oder (III), bezogen auf das Gewicht des Basispigments der Formel (I).

Pigmentzubereitungen, bestehend aus einer Dioxazinverbindung der Formel (I) als Basispigment und einer Dioxazinverbindung der allgemeinen Formel (II) als Pigmentdispergator, sind an sich bereits bekannt und z.B. in EP-A-0 321 919 oder EP-A-0 504 923 beschrieben. Die US, A, 4, 451, 398 beschreibt Zusammensetzungen aus P.V.23 und einem P.V.23-Derivat verwendet zur Papierfästung; in der JP-A-9 165 528 wird u.a. Konditioniertes P.V.23 in elektrophotographischen Tonern, Farbfiltern sowie Tintenstrahltinten eingesetzt. Neu und überraschend ist, dass diese Pigmentzubereitungen gegenüber dem Stand der Technik hervorragende anwendungstechnische Eigenschaften in den genannten Einsatzgebieten aufweisen. Beispielsweise zeichnen sich die Pigmentzubereitungen durch gute Dispergierbarkeit in den Anwendungsmedien, Stabilität und gute Fließfähigkeit der daraus hergestellten Dispersionen, Homogenität und Gleichmäßigkeit der zum Beispiel durch Spin Coating erzeugten Schichten, sowie hoher Transparenz und verbessertem Kontrast derartiger Schichten aus. Darüber hinaus weisen die Pigmentzubereitungen hohe Thermostabilität, Lösemittel- und Chemikalienbeständigkeit auf.

Weiterhin kann das Farbmittel durch Variation des Gehalts an Pigmentdispergator der Formel (II) an die spezifischen Anforderungen des Color Filter-Materials angepasst werden.

Die Herstellung der Colorfilter kann nach üblichen Verfahren erfolgen:
Die erfindungsgemäße Pigmentzubereitung wird in einem wässrigen oder nichtwässrigen System, das noch weitere Komponenten, wie z.B. Bindemittel, enthalten kann, dispergiert. Bindemittel können thermoplastisch, duroplastisch oder photoempfindlich sein. Beispiele von thermoplastischen und duroplastischen Bindemittel beinhalten Acrylate, Acrylester, Polyimide, Polyvinylalkohole, Epoxide, Polyester, Melamine, Gelatine, Caseine. Photoempfindliche Bindemittel sind an sich bekannt und beispielsweise in der US 6,284,432 offenbart. Die so hergestellte Color Filter-Paste hat eine Konzentration an Pigmentzubereitung von 2,5 bis 80 Gew.-%.

Diese Dispersionen (Color-Filter-Pasten) können dann mittels Spincoating oder geeigneten konventionellen Druckverfahren (z.B. Flexo-, Offset-, Screen-, Intaglio- und Stempeldruck) oder berührungslosen Druckverfahren (z.B. Ink Jet) auf das Color Filter -Trägermaterial, typischerweise eine Glasplatte, aufgebracht werden. Die Bildpunkte können auch durch Thermosublimation, Thermotransfer, Electrodeposition oder anderen geeigneten Aufbringungsverfahren erzeugt werden.

Die typische Einsatzkonzentration der erfindungsgemäßen Pigmentzubereitungen im aufgebrachten Color Filter-Film liegt zwischen 5 und 95 Gew.-%, bevorzugt zwischen 20 und 80 Gew.-%, ganz besonders bevorzugt zwischen 40 und 60 Gew.-%, bezogen auf das Gesamtgewicht des Color Filter-Filmes.

Das am häufigsten angewandte Verfahren ist Spincoaten. Hierbei werden in geeigneten Photoresistsystemen nacheinander die Bildpunkte, z.B. R, G, B aufgebracht.

Eine aufgebrachte Photoresistschicht wird z.B. Strahlung ausgesetzt, anschließend entwickelt, so dass nur einzelne Bildpunkte der farbigen Schicht zurückbleiben.

Dieses Verfahren wird dann für weitere Farben wiederholt, so dass zum Schluss gleich große R, G, B- oder Y, M, C-Bildpunkte (Pixel) nebeneinander stehen.

**Tabelle 1 gibt einen schematischen Überblick über typische Color-Filter Systeme:**

| | | | | |
|---|---|---|---|---|
| Aufbringverfahren | Photoresist Farbstoff | Photoresist Pigment | Pigmentiertes Drucken | Pigmentierte Elektrodeposition |
| Bindemittel | Gelatine, Casein, Acrylate, Polyimide | Acrylate, Polyimide, Polyvinylalcohol | Epoxyharz, Acrylate | Melamine, Polyester, Epoxyharz |
| Farbmittel | Farbstoff | Pigment | Pigment | Pigment |
| Filmdicke (µm) | 0,7-2,5 | 0,8-2,5 | 1,5-3,5 | 1,5-2,5 |
| Hitzestabilität (°C) | 180 | 220-300 | 250 | 250 |
| Lichtstabilität (h) | < 100 | > 500 | > 500 | > 500 |
| Chemische Widerstandsfähigkeit | schlecht | gut | gut | gut |
| Spektrum | sehr gut | gut | gut | gut |
| Oberfläche | gut | gut | gut | sehr gut |
| Auflösung (µm) | 7-20 | 10-20 | 70-100 | 10-20 |

Für die meisten Aufbringverfahren, wie z.B. das Photolitographische (Photoresisttechnologie) sind Lösemittel, bevorzugt organische Lösemittel, ein notwendiger Bestandteil.

Grundsätzlich geeignet sind alle polaren oder unpolaren organischen Lösemittel, die je nach Aufbringverfahren noch weitere Eigenschaften wie Wasserverträglichkeit oder -unverträglichkeit, Temperaturstabilität oder sicherheits- und ecotox-relevante Aspekte erfüllen müssen.

Übliche Lösemittel sind Ethylcellosolveacetat, Diethylenglykolalkylether (z.B. Diethylenglykolmonoethylether, Diethylenglykoldimethylether), Propylenglykolalkyletheracetate (z.B. Propylenglykolmonomethyletheracetat), Ethylenglykolalkyletheracetate (z.B. Ethylenglykolmonoethyletheracetat), N-Methylpyrrolidon, Ketone (z.B. Methylethylketone, Cyclohexanon und Cyclopentanon), Alkohole, aromatische Kohlenwasserstoffe, Ester (z.B. Ethyl-3-ethoxypropionat), cyclische Ester.

Diese Lösemittel können einzeln oder in Kombination miteinander eingesetzt werden.

Die erfindungsgemäßen Pigmentzubereitungen sind auch geeignet als Farbmittel in elektrophotographischen Tonern und Entwicklern, wie beispielsweise Ein- oder Zweikomponentenpulvertonern (auch Ein- oder Zweikomponenten-Entwickler genannt), Magnettoner, Flüssigtoner, Latextoner, Polymerisationstoner sowie Spezialtoner. Tonerpartikeln können auch für kosmetische und pharmazeutische Anwendungen, z.B. zum Coaten von Tabletten, verwendet werden.

Typische Tonerbindemittel sind Polymerisations-, Polyadditions- und Polykondensationsharze, wie Styrol-, Styrolacrylat-, Styrolbutadien-, Acrylat-, Polyester-, Phenol-Epoxidharze, Polysulfone, Polyurethane, einzeln oder in Kombination, sowie Polyethylen und Polypropylen, die noch weitere Inhaltsstoffe, wie Ladungssteuermittel, Wachse oder Fließhilfsmittel, enthalten können oder im nachhinein mit diesen Zusätzen modifiziert werden.

Elektrophotographische Toner oder Entwickler enthalten ein übliches Tonerbindemittel und zwischen 0,1 und 80 Gew.-%, bevorzugt zwischen 1 und 40 Gew.-% und besonders bevorzugt zwischen 3 und 20% Gew.-% einer erfindungsgemäßen Pigmentzubereitung und zwischen 0 und 20 Gew.-%, bevorzugt zwischen 0,1 und 5 Gew.-%, jeweils bezogen auf das Gesamtgewicht des Toners oder Entwicklers, eines Ladungssteuermittel aus der Klasse der Triphenylmethane, Ammonium- und Immoniumverbindungen; fluorierten Ammonium- und Immoniumverbindungen; biskationischen Säureamide; polymeren Ammoniumverbindungen; Diallylammoniumverbindungen, Arylsulfid-Derivate, Phenolderivate, Phosphoniumverbindungen, und fluorierten Phosphoniumverbindungen; Calix(n)arene; Cyclodextrine; Polyestersalze; Metallkomplexverbindungen; Cyclooligosaccharid-Borkomplexe, Inter-Polyelektrolyt-Komplexe; Benzimidazolone; Azine, Thiazine oder Oxazine.

Elektrophotographische Toner können auch weiterhin noch Wachse enthalten. Des weiteren können Wachse auch als vordispergiertes Konzentrat verwendet werden, wobei die Konzentrate (Masterbatch) Mehrkomponente sein können: Komponente sind die erfindungsgemäßen Farbmittel, Harze, Ladungssteuermittel und deren Kombinationen.

Die erfindungsgemäßen Pigmentzubereitungen weisen einen ausgeprägten neutralen und stabilen triboelektrischen Eigeneffekt beim Einsatz in elektrophotographischen Tonern und Entwicklern auf.

Außerdem sind die erfindungsgemäßen Pigmentzubereitungen geeignet als Farbmittel in Ink-Jet Tinten auf wässriger und nichtwässriger Basis, in Mikroemulsionstinten sowie in solchen Tinten, die nach dem Hot-melt-Verfahren arbeiten.

Ink-Jet-Tinten enthalten im Allgemeinen insgesamt 0,5 bis 25 Gew.-%, vorzugsweise 1,5 bis 8 Gew.-%, (trocken gerechnet) einer erfindungsgemäßen Pigmentzubereitung.

Mikroemulsionstinten basieren auf organischen Lösemitteln, Wasser und ggf. einer zusätzlichen hydrotropen Substanz (Grenzflächenvermittler). Mikroemulsionstinten enthalten im Allgemeinen 0,5 bis 15 Gew.-%, vorzugsweise 1,5 bis 8 Gew.-%, einer erfindungsgemäßen Pigmentzubereitung, 5 bis 99 Gew.-% Wasser und 0,5 bis 94,5 Gew.-% organisches Lösungsmittel und/oder hydrotrope Verbindung.

"Solvent based" Ink-Jet-Tinten enthalten vorzugsweise 0,5 bis 15 Gew.-% einer erfindungsgemäßen Pigmentzubereitung, 85 bis 99,5 Gew.-% organisches Lösungsmittel und/oder hydrotrope Verbindungen.

Hot-Melt-Tinten basieren meist auf Wachsen, Fettsäuren, Fettalkoholen oder Sulfonamiden, die bei Raumtemperatur fest sind und bei Erwärmen flüssig werden, wobei der bevorzugte Schmelzbereich zwischen ca. 60°C und ca. 140°C liegt. Hot-Melt Ink-Jet-Tinten bestehen z.B. im Wesentlichen aus 20 bis 90 Gew.-% Wachs und 1 bis 10 Gew.-% einer erfindungsgemäßen Pigmentzubereitung. Weiterhin können 0 bis 20 Gew.-% eines zusätzlichen Polymers (als "Farbstofflöser"), 0 bis 5 Gew.-% Dispergierhilfsmittel, 0 bis 20 Gew.-% Viskositätsveränderer, 0 bis 20 Gew.-% Plastifizierer, 0 bis 10 Gew.-% Klebrigkeitszusatz, 0 bis 10 Gew.-% Transparenzstabilisator (verhindert z.B. Kristallisation der Wachse) sowie 0 bis 2 Gew.-% Antioxidans enthalten sein.

Weiterhin sind die erfindungsgemäßen Pigmentzubereitungen auch als Farbmittel für elektronische Tinten ("electronic inks" bzw. "e-inks") oder "electronic paper" ("e-paper") geeignet.

Die erfindungsgemäßen violetten Pigmentzubereitungen können einzeln oder in Kombination mit geeigneten organischen oder anorganischen Pigmenten, oder in Kombination mit Farbstoffen eingesetzt werden, und zwar als Mischung in der Dispersion (Color Filter paste). Die Pigmentzubereitungen dienen entweder als Nuancierfarbmittel, die in Mengen von 1 Gew.-% bis 49 Gew.-% zugegeben werden können, wie z.B. beim Nuancieren von Pigment Blue 15, oder die Pigmentzubereitungen sind die Hauptkomponenten.

Als organische Pigmente kommen prinzipiell alle Monoazo-, Disazo-, verlackte Azo-, ß-Naphthol-, Naphthol AS-, Benzimidazolon-, Disazokondensations-, Azo-Metallkomplex-Pigmente und polycyclische Pigmente wie zum Beispiel Phthalocyanin-, Chinacridon-, Perylen-, Perinon-, Thioindigo-, Anthrathron-, Anthrachinon-, Flavanthron, Indanthron-, Isoviolanthron-, Pyranthron-, Dioxazin-, Chinophthalon-, Isoindolinon-, Isoindolin- und Diketopyrrolopyrrol-Pigmente oder Ruße in Betracht.

Insbesondere eignen sich auch oberflächenmodifizierte Pigmente, deren Oberfläche durch chemische Prozesse wie beispielsweise Sulfonierung oder Diazotierung verändert und mit funktionellen, gegebenenfalls ladungstragenden Gruppen oder Polymerketten versehen wurde (in der englischsprachigen Literatur als self-dispersing bzw. graft pigments bezeichnet).

Geeignete anorganische Pigmente sind beispielsweise Titandioxide, Zinksulfide, Eisenoxide, Chromoxide, Ultramarin, Nickel- oder Chromantimontitanoxide, Cobaltoxide sowie Bismutvanadate.

Als organische Farbstoffe kommen bevorzugt lösemittellösliche Farbstoffe, wie Solvent Dyes und Fettfarbstoffe, aber auch Säurefarbstoffe, Direktfarbstoffe, Schwefelfarbstoffe und deren Leukoform, Metallkomplexfarbstoffe oder Reaktivfarbstoffe in Betracht, wobei im Falle der Reaktivfarbstoffe auch mit Nukleophilen abreagierte Farbstoffe eingesetzt werden können.

Als beispielhafte Auswahl besonders bevorzugter organischer Pigmente sind dabei Rußpigmente, wie z.B. Gas- oder Furnaceruße; Monoazo- und Disazopigmente, insbesondere die Colour Index Pigmente, einzeln oder in Kombination, wie z.B.:
Pigment Red 2, Pigment Red 3, Pigment Red 4, Pigment Red 5, Pigment Red 9, Pigment Red 12, Pigment Red 14, Pigment Red 38, Pigment Red 48:2, Pigment Red 48:3, Pigment Red 48:4, Pigment Red 53:1, Pigment Red 57:1, Pigment Red 112, Pigment Red 122, Pigment Red 144, Pigment Red 146, Pigment Red 147, Pigment Red 149, Pigment Red 168, Pigment Red 169, Pigment Red 170, Pigment Red 175, Pigment Red 176, Pigment Red 177, Pigment Red 179, Pigment Red 181, Pigment Red 184, Pigment Red 185, Pigment Red 187, Pigment Red 188, Pigment Red 207, Pigment Red 208, Pigment Red 209, Pigment Red 210, Pigment Red 214, Pigment Red 242, Pigment Red 247, Pigment Red 253, Pigment Red 254, Pigment Red 256, Pigment Red 257, Pigment Red 262, Pigment Red 263, Pigment Red 266, Pigment Red 269, Pigment Red 274, Pigment Violet 19 oder Pigment Violet 32;
   Pigment Yellow 1, Pigment Yellow 3, Pigment Yellow 12, Pigment Yellow 13, Pigment Yellow 14, Pigment Yellow 16, Pigment Yellow 17, Pigment Yellow 73, Pigment Yellow 74, Pigment Yellow 81, Pigment Yellow 83, Pigment Yellow 87, Pigment Yellow 97, Pigment Yellow 111, Pigment Yellow 120, Pigment Yellow 126, Pigment Yellow 127, Pigment Yellow 128, Pigment Yellow 139, Pigment Yellow 151, Pigment Yellow 154, Pigment Yellow 155, Pigment Yellow 173, Pigment Yellow 174, Pigment Yellow 175, Pigment Yellow 176, Pigment Yellow 180, Pigment Yellow 181, Pigment Yellow 191, Pigment Yellow 194, Pigment Yellow 196, Pigment Yellow 213, Pigment Yellow 214;
   Pigment Orange 5, Pigment Orange 13, Pigment Orange 34, Pigment Orange 36, Pigment Orange 38, Pigment Orange 43, Pigment Orange 62, Pigment Orange 68, Pigment Orange 70, Pigment Orange 72 oder Pigment Orange 74; Pigment Green 7 oder Pigment Green 36 Pigment Blue 15, Pigment Blue 15:1, Pigment Blue 15:2, Pigment Blue 15:3, Pigment Blue 15:4, Pigment Blue 15:6, Pigment Blue 16, Pigment Blue 56, Pigment Blue 60 oder Pigment Blue 61.

Bevorzugt werden die erfindungsgemäßen Pigmentzubereitungen zum Nuancieren von Grün-, Blau- und Rot-Pigmenten eingesetzt, besonders bevorzugt mit Pigmenten auf Basis von P. Blue 15, 15:1, 15:2, 15:3, 15:4 und 15:6.

### Beispiele:

### Herstellung eines Test-Color Filters:

Es wird zunächst eine Color Filter-Paste hergestellt, die aus Pigmentzubereitung, Bindemittel, Lösemittel und Dispergierhilfsmittel nach folgender Rezeptur besteht:

| | |
|---|---|
| 87 Gew.-% | Basisfirnis (davon sind 89% ein Lösemittelgemisch aus 60 % 1-Methoxy-2-propylacetat, 30 % Ethyl 3-ethoxypropionat, 10 % Cyclohexanon; und 11 % sind ein Styrolacrylpolymer); |
| 10 Gew.-% | Pigmentzubereitung; und |
| 3 Gew.-% | Disperbyk^{®} 161. |

Die vorstehende Mischung wird mit Zirkonkugeln (Ø 0,5-0,7 mm) in einem Paint Shaker für 3 Stunden dispergiert. Die Color Filter-Paste wird anschließend filtriert und mit dem im Basisfirnis enthaltenen Lösemittelgemisch verdünnt, bis der Anteil der Pigmentzubereitung in der Paste 6 Gew.-% beträgt.

Die verdünnte Color Filter-Paste wird auf ein Glassubstrat mittels Spin Coater aufgetragen, um einen Color Filter-Film zu erzeugen. Die eingestellte Geschwindigkeit des Spin Coaters bestimmt die Schichtdicke des Color Filter-Filmes (je schneller, desto dünner), die wiederum einen Einfluss auf die Transparenz hat (je dicker der Film ist, desto mehr absorbiert der Film). Die Schichtdicke ist meist unter 1 µm. Die Transparenz und der Kontrast werden an diesem Color Filter-Film bestimmt.

Die Transmission des beschichteten Glassubstrates wird spektrophotometrisch in dem Anwendungsbereich von 400-700 nm ermittelt. Transmissionswerte werden bei 31 Wellenlängen erfasst. Zur Beschreibung der Coloristik wird das CIE L*a*b* Farbmodell herangezogen. L* beschreibt dabei die Helligkeit, wobei der Zahlenwert 0 für schwarz und 100 für weiß steht. a* beschreibt die rot-grün Achse, b* die blau-gelb Achse.

Die Dispergierbarkeit der erfindungsgemäßen Pigmentzubereitung wird mittels Viskositätsmessung sichergestellt. Die Viskosität wird an der oben beschriebenen verdünnten Color Filter-Paste ermittelt. Die Messung erfolgt mittels eines Rotationsviskosimeters (Typ RS75, Fa. Haake), bei einer Temperatur von 23°C ± 0,5°C und bei einer Schergeschwindigkeit von 60s⁻¹.

### Beispiel für die Synthese eines Pigmentdispergators

In 1500 Teile Polyphosphorsäure werden bei 120°C 60 Teile Rohpigment Violett 23 (salzfrei) eingetragen. Nach einstündigem Rühren werden langsam 28,7 Teile 4-Methyl-5-hydroxymethylimidazol Hydrochlorid zugesetzt. Anschließend wird 5 Stunden bei 120°C gerührt. Die Reaktionslösung wird danach auf Eiswasser ausgetragen, mit konz. Natronlauge auf pH 10 gestellt und über Nacht stehengelassen. Anschließend wird der Niederschlag abgesaugt, mit Wasser neutral und salzfrei gewaschen und bei 50°C getrocknet. Man erhält 73 Teile des Pigmentdispergators der Formel (III) mit m gleich 1.

### Beispiel 1

### a) Synthese Pigmentcrude

30 Teile grobkristallines Rohpigment (Pigment Violet 23), hergestellt in salzfreier Form entsprechend BIOS Final Report 960, Seite 75, werden in ein zylindrisches 1-Liter-Kunststoffgefäß eingebracht, das mit 1400 g Cylpebs (aus Korund, von 12 mm Durchmesser, Hersteller: Groß GmbH, Hof) als Mahlkörper gefüllt ist. Das Gemisch wird nun 4 Stunden lang unter Schütteln auf einer Schwingmühle vom Typ Vibratom^{®} (Hersteller: Siebtechnik Mühlheim) fein vermahlen. Danach wird das Mahlgut von den Mahlkörpern abgesiebt. Man erhält 29 g Mahlgut.

### b) Finish

Zu 103,0 Teilen Wasser und 37,2 Teilen Isobutanol fügt man 29 Teile Mahlgut aus Rohpigment P.V. 23. Nach mehrstündigem Rühren bei Siedetemperatur werden 23,7 Teile einer 10 gew.-%igen wässrigen Suspension des Pigmentdispergators der Formel (III) mit m gleich 1, hergestellt wie in vorstehendem Synthesebeispiel beschrieben, zugegeben, das Lösemittel abdestilliert und mit 18,7 Teilen Wasser verdünnt.

### c) Aufarbeitung

Anschließend wird der Ansatz heiß abgesaugt. Das Produkt wird salzfrei gewaschen und bei 80°C im Vakuum getrocknet.

### d) Mahlung

Die erhaltenen 31,0 Teile der Pigmentzubereitung werden über eine Stiftmühle gemahlen. Man erhält ein gut kristallines Pulver mit einem Röntgen-Index von 7,31 und einer BET-Oberfläche von 93,2 m²/g.

Die Untersuchung der Teilchengrößenverteilung der Primärteilchen liefert folgende Kenngrößen:
d₂₅ = 37 nm, d₅₀ = 47 nm, d₇₅ = 60 nm.
Länge zu Breiteverhältnis: 1,45:1

### Bestimmung der Transmission und Coloristik:

Es wird eine Color Filter-Paste gemäß vorstehend beschriebener Vorschrift hergestellt. Die Viskosität der Color Filter-Paste beträgt: η = 13,6 mPa.s. Anschließend werden 3 mL von der verdünnten Color Filter-Paste pipettiert und auf ein Glassubstrat mittels Spin Coater bei einer Drehgeschwindigkeit von 2500 rpm während 20s aufgetragen. Die coloristischen Eigenschaften des Color Filter-Films werden anschließend spektrophotometrisch bestimmt.

### Coloristik:

| L* | a* | b* |
|---|---|---|
| 49,88 | 47,83 | -60,12 |

### Transmissionswerte des Color Filter-Films:

| | | | | | | |
|---|---|---|---|---|---|---|
| Wellenlänge | 400 nm | 410 nm | 420 nm | 430 nm | 440 nm | 450 nm |
| Transmission (%) | 64,2 | 67,6 | 70,4 | 72,4 | 73,1 | 71,6 |
| Wellenlänge | 460 nm | 470 nm | 480 nm | 490 nm | 500 nm | |
| Transmission (%) | 68,2 | 62,6 | 53,2 | 39,3 | 25,7 | |
| Wellenlänge | 510 nm | 520 nm | 530 nm | 540 nm | 550 nm | 560 nm |
| Transmission (%) | 15,4 | 8,3 | 5,3 | 5,2 | 5,7 | 5,6 |
| Wellenlänge | 570 nm | 580 nm | 590 nm | 600 nm | 610 nm | |
| Transmission (%) | 6,6 | 11,1 | 19,8 | 28,1 | 29,7 | |
| Wellenlänge | 620 nm | 630 nm | 640 nm | 650 nm | 660 nm | 670 nm |
| Transmission (%) | 26,1 | 26,4 | 34,8 | 48,8 | 62,7 | 72,6 |
| Wellenlänge | 680 nm | 690 nm | 700 nm | | | |
| Transmission (%) | 78,5 | 81,8 | 83,7 | | | |

### Bestimmung der Teilchengrößenverteilung:

Mittels Scheibenzentrifuge wird die Teilchengrößenverteilung von der verdünnten Color Filter Paste ermittelt. Um die Messung durchführen zu können, wird ein Dichte-Gradient hergestellt. Er besteht aus den Bestandteilen des für die Herstellung von Color Filter Pasten eingesetzten Basisfirnis.

| Maximum-Peak | Halbwertsbreite | d₅₀ |
|---|---|---|
| 67,6 nm | 52,9 nm | 68,9 nm |

### Elektrostatische Eigenschaften (Toner):

5 Teile der Pigmentzubereitung werden mittels eines Kneters innerhalb von 30 Min. in 95 Teile eines Tonerbindermittels (Styrol-Acrylat-Copolymer 60:40, Dialec^{®} S309, Fa. Diamond Shamrock) homogen eingearbeitet. Anschließend wird auf
einer Labor-Universalmühle gemahlen und dann auf einem Zentrifugalsichter klassifiziert. Die gewünschte Fraktion (4 bis 25 µm) wird mit einem Carrier aktiviert, der aus mit Styrol-Methacryl-Copolymerisat (90:10) beschichteten Magnetit-Teilchen besteht.

Die Messung erfolgt an einem üblichen q/m Messstand. Durch Verwendung eines Siebes mit einem Maschenweite von 25 µm wird sichergestellt, dass bei den Tonerausblasungen kein Carrier mitgerissen wird. Die Messungen erfolgen bei ca. 50%iger relativer Luftfeuchtigkeit. In Abhängigkeit von der Aktivierdauer werden folgende q/m-Werte (µC/g) gemessen:

| Aktivierdauer | Aufladung q/m |
|---|---|
| 5 Min. | + 2,3 µC/g |
| 10 Min. | + 2,2 µC/g |
| 30 Min. | + 2,3 µC/g |
| 120 Min | + 2,2 µC/g |

### Beispiel 2

### a) Pigmentcrude

Die Herstellung erfolgt wie in Beispiel 1a).

### b) Finish

Die Herstellung erfolgt wie in Beispiel 1 b), außer dass 27,4 Teile einer 10 gew.-%igen wässrigen Suspension des Pigmentdispergators der Formel (III) mit m gleich 1 zugesetzt werden.

### c) Aufarbeitung und d) Mahlung erfolgen wie in Beispiel 1.

Man erhält ein gut kristallines Pulver mit einem Röntgen-Index von 7,11 und einer BET-Oberfläche von 93,7 m²/g.

Die Untersuchung der Teilchengrößenverteilung der Primärteilchen liefert folgende Kenngrößen:
d₂₅ = 50 nm, d₅₀ = 78 nm, d75 = 203 nm.
Länge zu Breiteverhältnis: 1,67:1

Die Bestimmung der Transmission erfolgt analog zu Beispiel 1.

### Coloristik:

| L* | a* | b* |
|---|---|---|
| 46,01 | 52,58 | -64,19 |

### Transmissionswerte des Color Filter Films:

| | | | | | | |
|---|---|---|---|---|---|---|
| Wellenlänge | 400 nm | 410 nm | 420 nm | 430 nm | 440 nm | 450 nm |
| Transmission (%) | 61,2 | 65,2 | 68,3 | 70,4 | 71,0 | 69,1 |
| Wellenlänge | 460 nm | 470 nm | 480 nm | 490 nm | 500 nm | |
| Transmission (%) | 65,2 | 58,8 | 48,5 | 34,0 | 20,6 | |
| Wellenlänge | 510 nm | 520 nm | 530 nm | 540 nm | 550 nm | 560 nm |
| Transmission (%) | 11,3 | 5,5 | 3,2 | 3,1 | 3,6 | 3,5 |
| Wellenlänge | 570 nm | 580 nm | 590 nm | 600 nm | 610 nm | |
| Transmission (%) | 4,5 | 8,5 | 16,5 | 24,1 | 25,3 | |
| Wellenlänge | 620 nm | 630 nm | 640 nm | 650 nm | 660 nm | 670 nm |
| Transmission (%) | 21,8 | 22,3 | 31,0 | 45,7 | 61,1 | 72,9 |
| Wellenlänge | 680 nm | 690 nm | 700 nm | | | |
| Transmission (%) | 80,3 | 84,6 | 87,0 | | | |

### Bestimmung der Viskosität:

Die Color Filter-Paste aus Beispiel 2 wird wie in Beispiel 1 vermessen.

Die Viskosität beträgt: η = 22,8 mPas.

### Bestimmung der Teilchengrößenverteilung:

Die Color Filter-Paste aus Beispiel 2 wird wie in Beispiel 1 vermessen.

| Maximum-Peak | Halbwertsbreite | d₅₀ |
|---|---|---|
| 70,6 nm | 53,3 nm | 71,2 nm |

### Elektrostatische Eigenschaften (Toner):

Es wird ein Testtoner analog zu Beispiel 1 hergestellt und vermessen, wobei an Stelle von 5 Teilen der Pigmentzubereitung aus Beispiel 1 jetzt 5 Teile Pigmentzubereitung aus Beispiel 2 eingearbeitet werden: In Abhängigkeit von der Aktivierdauer werden folgende q/m-Werte gemessen:

| Aktivierdauer | Aufladung q/m |
|---|---|
| 5 Min. | + 3,1 µC/g |
| 10 Min. | + 2,9 µC/g |
| 30 Min. | + 2,6 µC/g |
| 120 Min | + 2,9 µC/g |

### Beispiel 3:

### a) Pigmentcrude

Die Herstellung erfolgt wie in Beispiel 1 a).

### b) Finish

Die Herstellung erfolgt wie in Beispiel 1 b), außer dass 31,1 Teile einer 10 gew.-%igen wässrigen Suspension des Pigmentdispergators der Formel (III) mit m gleich 1 zugesetzt werden.

Aufarbeitung und Mahlung erfolgen wie in Beispiel 1.

Man erhält ein gut kristallines Pulver mit einem Röntgen-Index von 6,48 und einer BET-Oberfläche von 99,0 m²/g.

Die Untersuchung der Teilchengrößenverteilung der Primärteilchen liefert folgende Kenngrößen:
d₂₅ = 31 nm, d₅₀ = 39 nm, d₇₅ = 50 nm.
Länge zu Breiteverhältnis: 1,52:1

Die Bestimmung der Transmission erfolgt analog zu Beispiel 1.

### Coloristik:

| L* | a* | b* |
|---|---|---|
| 49,00 | 48,42 | -61,05 |

### Transmissionswerte des Color Filter Films:

| | | | | | | | |
|---|---|---|---|---|---|---|---|
| Wellenlänge | 400nm | 410nm | 420nm | 430nm | 440nm | 450nm | 460nm |
| Transmission (%) | 63,8 | 67,2 | 69,9 | 71,8 | 72,5 | 71,0 | 67,7 |
| Wellenlänge | 470nm | 480nm | 490nm | 500nm | | | |
| Transmission (%) | 62,0 | 52,5 | 38,5 | 24,8 | | | |
| Wellenlänge | 510nm | 520nm | 530nm | 540nm | 550nm | 560nm | 570nrr |
| Transmission (%) | 14,6 | 7,6 | 4,7 | 4,6 | 5,2 | 5,0 | 6,0 |
| Wellenlänge | 580nm | 590nm | 600nm | 610nm | | | |
| Transmission (%) | 10,4 | 19,0 | 27,3 | 28,8 | | | |
| Wellenlänge | 620nm | 630nm | 640nm | 650nm | 660nm | 670nm | 680nm |
| Transmission (%) | 25,2 | 25,5 | 34,0 | 48,4 | 62,8 | 73,0 | 78,9 |
| Wellenlänge | 690nm | 700nm | | | | | |
| Transmission (%) | 82,2 | 83,9 | | | | | |

### Bestimmung der Viskosität:

Die Viskosität der Color Filter-Paste beträgt: η = 13,7 mPas.

### Bestimmung der Teilchengrößenverteilung:

Die Color Filter-Paste aus Beispiel 3 wird wie in Beispiel 1 vermessen.

| Maximum-Peak | Halbwertsbreite | d₅₀ |
|---|---|---|
| 62,3nm | 49,5nm | 61,7nm |

### Elektrostatische Eigenschaften (Toner):

Es wird ein Testtoner analog zu Beispiel 1 hergestellt und vermessen, wobei an Stelle von 5 Teilen der Pigmentzubereitung aus Beispiel 1 jetzt 5 Teile Pigmentzubereitung aus Beispiel 3 eingearbeitet werden. In Abhängigkeit von der Aktivierdauer werden folgende q/m-Werte gemessen:

| Aktivierdauer | Aufladung q/m |
|---|---|
| 5 Min. | + 1,1 µC/g |
| 10 Min. | + 1,5 µC/g |
| 30 Min. | + 1,3 µC/g |
| 120 Min | + 1,8 µC/g |

### Beispiel 4:

### a) Synthese des Pigmentcrudes:

In eine Rührwerkskugelmühle vom Typ Drais PML (Hersteller: Draiswerke GmbH, Mannheim), die mit 336 g Zirkoniummischoxidperlen vom Durchmesser 0,3-0,4 mm als Mahlkörper gefüllt ist, werden nacheinander 85 g Wasser und 15 g grobkristallines Rohpigment (Pigment Violet 23) eingetragen und darin mit einer Rührwerksumfanggeschwindigkeit von 15,6 m/s sowie einer spezifischen Leistungsdichte von 3,1 kW pro Liter Mahlraum 10 Minuten lang bei 30°C gemahlen.

Anschließend wird die Mahlgutsuspension von den Mahlkörpern abgesiebt, die Mahlkörper werden mit Wasser abgespült und die vereinigten Mahlgutsuspensionen abgesaugt.

### b) Finish

Der Filterrückstand wird in Wasser aufgenommen, so dass 150 ml einer wässrigen Suspension vorliegen, zu der 45 g Isobutanol gegeben werden. Nach einer Nachrührzeit von 24 h und mehrstündigem Rühren bei Siedetemperatur werden 7,5 Teile einer wässrigen Suspension des Pigmentdispergators (10 Gew.-%) zugegeben, das Lösemittel abdestilliert und mit 18,7 Teilen Wasser verdünnt.

Aufarbeitung und Mahlung erfolgen wie in Beispiel 1.
Man erhält ein gut kristallines Pulver mit einem Röntgen-Index von 8,92 und einer BET-Oberfläche von 69,5 m²/g.

Die Untersuchung der Teilchengrößenverteilung der Primärteilchen liefert folgende Kenngrößen:
d₂₅ = 47 nm, d₅₀ = 63 nm, d₇₅ = 94 nm.
Länge zu Breiteverhältnis: 1,80:1

### Coloristik:

| L* | a* | b* |
|---|---|---|
| 50,5 | 44,56 | -59,09 |

### Transmissionswerte des Color Filter Films:

| | | | | | | |
|---|---|---|---|---|---|---|
| Wellenlänge | 400 nm | 410 nm | 420 nm | 430 nm | 440 nm | 450 nm |
| Transmission (%) | 63,9 | 67,3 | 70,0 | 72,0 | 72,7 | 71,3 |
| Wellenlänge | 460 nm | 470 nm | 480 nm | 490 nm | 500 nm | |
| Transmission (%) | 68,1 | 62,8 | 53,8 | 40,5 | 27,3 | |
| Wellenlänge | 510 nm | 520 nm | 530 nm | 540 nm | 550 nm | 560 nm |
| Transmission (%) | 17,2 | 9,8 | 6,4 | 6,1 | 6,7 | 6,4 |
| Wellenlänge | 570 nm | 580 nm | 590 nm | 600 nm | 610 nm | |
| Transmission (%) | 7,1 | 11,1 | 19,2 | 27,6 | 29,6 | |
| Wellenlänge | 620 nm | 630 nm | 640 nm | 650 nm | 660 nm | 670 nm |
| Transmission (%) | 25,9 | 25,4 | 32,8 | 46,3 | 60,6 | 71,1 |
| Wellenlänge | 680 nm | 690 nm | 700 nm | | | |
| Transmission (%) | 77,5 | 81,1 | 83,2 | | | |

### Bestimmung der Viskosität:

Die Viskosität der Color Filter-Paste beträgt η = 19,9 mPas.

### Bestimmung der Teilchengrößenverteilung:

Die Color Filter-Paste aus Beispiel 4 wird wie in Beispiel 1 vermessen.

| Maximum-Peak | Halbwertsbreite | d₅₀ |
|---|---|---|
| 69,9 nm | 71,8 nm | 69 nm |

### Elektrostatische Eigenschaften (Toner):

Es wird ein Testtoner analog zu Beispiel 1 hergestellt und vermessen, wobei an Stelle von 5 Teilen der Pigmentzubereitung aus Beispiel 1 jetzt 5 Teile Pigmentzubereitung aus Beispiel 4 eingearbeitet werden. In Abhängigkeit von der Aktivierdauer werden folgende q/m-Werte gemessen:

| Aktivierdauer | Aufladung q/m |
|---|---|
| 5 Min. | + 0,7 µC/g |
| 10 Min. | + 0,9 µC/g |
| 30 Min. | + 0,4 µC/g |
| 120 Min | + 0,6 µC/g |

## Patentansprüche

1. Verwendung einer Pigmentzubereitung, **gekennzeichnet durch** einen Gehalt an
a) einer Dioxazinverbindung der Formel (I) als Basispigment 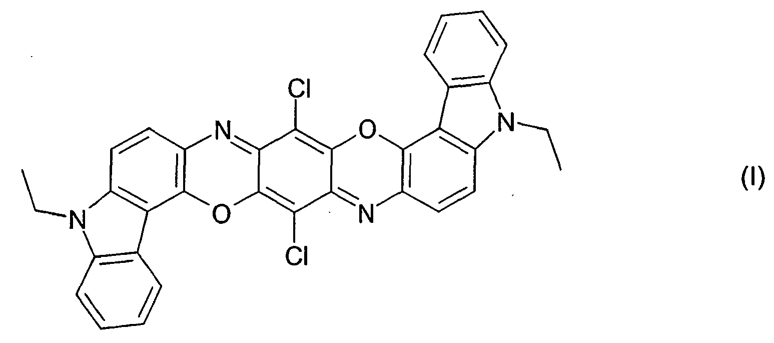 und
b) einer Dioxazinverbindung der allgemeinen Formel (II) als Pigmentdispergator
Q-[Y-X]ₘ (II)
worin
Q für einen m-wertigen Rest des Basispigments der Formel (I) steht,
Y eine brückenbildende Gruppierung aus der Reihe -(CR¹R²)ₓ- mit x gleich 1 bis 6, substituiertes oder unsubstituiertes Phenylen, -CO-, oder -NR³- oder eine sich gegebenenfalls wiederholende Kombination von mindestens zwei solcher Brückenglieder unterschiedlichen Typs bezeichnet, wobei R¹, R² und R³ unabhängig voneinander Wasserstoff oder C₁-C₄-Alkyl bedeuten,
X den Rest eines über ein C-Atom an das Brückenglied Y gebundenen, aliphatischen oder aromatischen, fünf-, sechs- oder siebengliedrigen heterocyclischen Systems mit jeweils 1 bis 3 ringangehörigen, gleichen oder unterschiedlichen Heteroatomen aus der Reihe Stickstoff, Sauerstoff oder Schwefel darstellt, das ggf. noch einen benzokondensierten Ring
aufweist und **durch** C₁-C₄-Alkyl, C₂-C₄-Alkenyl, C₁-C₃-Hydroxyalkyl oder Phenyl substituiert sein kann;
oder einen über den Imidstickstoff an das Brückenglied Y gebundenen Phthalimido-Rest darstellt, der am benzoiden Ring bis maximal vierfach durch Chlor, Brom, Nitro, Carboxy, N-(C₁-C₅-Alkyl)-carbamoyl, N-Phenylcarbamoyl oder Benzoylamino substituiert sein kann;
oder einen Rest -NR⁴R⁵ darstellt, in dem R⁴ und R⁵ unabhängig voneinander jeweils Wasserstoff, substituiertes oder unsubstituiertes C₁-C₂₀-Alkyl oder C₂-C₂₀-Alkenyl, C₅-C₆-Cycloalkyl, substituiertes oder unsubstituiertes Phenyl, Benzyl oder Naphthyl sind;
oder in dem die Gruppe -NR⁴R⁵ ein aliphatisches oder aromatisches, fünf-, sechs- oder siebengliedriges heterocyclisches System mit jeweils 1 bis 3 ringangehörigen, gleichen oder unterschiedlichen Heteroatomen aus der Reihe Stickstoff, Sauerstoff oder Schwefel bildet, das ggf. noch einen benzokondensierten Ring aufweist und **durch** Hydroxy, Oxo, C₁-C₄-Alkyl, C₂-C₄-Alkenyl, C₁-C₃-Hydroxyalkyl oder Phenyl substituiert sein kann, und
m einen Zahlenwert zwischen 1 und 4 angibt,
als Farbmittel in Color Filtern, Ink Jet Tinten, elektrophotographischen Tonern und Entwicklern und electronic inks.

2. Verwendung nach Anspruch 1, **dadurch gekennzeichnet, dass**
Y die Bedeutung -(CH₂)ₚ-, -CO-NR³-(CH₂)ₚ-, -CH₂-NR³-CO-(CH₂)ₚ- oder -CH₂-NR³-CO-CH₂-NH-(CH₂)ₙ- hat, in denen R³ Wasserstoff oder C₁-C₄-Alkyl bedeutet, sowie n und p unabhängig voneinander jeweils Zahlenwerte von 1 bis 6 darstellen,
X den Rest eines über ein C-Atom an das Brückenglied Y gebundenes Furan, Thiophen, Pyrrol, Pyrazol, Thiazol, Oxazol, Triazol, Imidazol, Thionaphthen, Benzoxazol, Benzothiazol, Benzimidazol, Benzotriazol oder Indol;
oder einen Rest -NR⁴R⁵ darstellt, in dem R⁴ und R⁵ unabhängig voneinander jeweils Wasserstoff, ggf. substituiertes C₁-C₆-Alkyl oder C₂-C₆-Alkenyl, C₅-C₆-Cycloalkyl, ggf. substituiertes Phenyl, Benzyl oder Naphthyl sind;
oder in dem die Gruppe -NR⁴R⁵ ein Pyrrolinyl, Pyrrolidinyl, Piperidinyl, Morpholinyl Homopiperidinyl oder Imidazolyl bedeutet, das ggf. noch einen
benzokondensierten Ring aufweist und durch Hydroxy, Oxo, C₁-C₄-Alkyl, C₁-C₃-Hydroxyalkyl oder Phenyl substituiert sein kann, und
m eine Zahl von 1 bis 3 ist.

3. Verwendung nach Anspruch 1 oder 2, **dadurch gekennzeichnet, dass** Y -(CH₂)₁₋₃-, -CO-NH-(CH₂)₁₋₃-, -CH₂-NH-CO-(CH₂)₁₋₃- oder -CH₂-NH-CO-CH₂-NH-(CH₂)₂₋₃-,
X über den Imidstickstoff oder die Positionen 4 oder 5 an das Brückenglied Y gebundenes Imidazolyl oder einen Rest -NR⁴R⁵ bezeichnet, wobei R⁴ und R⁵ Wasserstoff oder C₁-C₄-Alkyl darstellen, und
m eine Zahl von 1 bis 2,5 ist.

4. Verwendung nach mindestens einem der Ansprüche 1 bis 3, **dadurch gekennzeichnet, dass** der Pigmentdispergator eine Verbindung der Formel (III) ist, 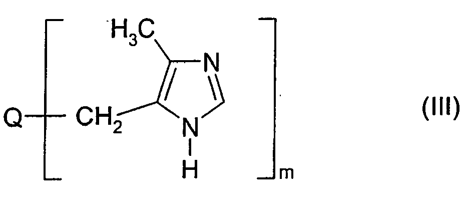 worin
m für einen Zahlenwert von 1 bis 4 steht.

5. Verwendung nach Anspruch 4, **dadurch gekennzeichnet, dass** m eine Zahl von 1 bis 2 ist.

6. Verwendung nach mindestens einem der Ansprüche 1 bis 5, **dadurch gekennzeichnet, dass** die Pigmentzubereitung 0,5 bis 99 Gew.-% an Pigmentdispergator der Formel (II) oder (III), bezogen auf das Gewicht des Basispigments der Formel (I), enthält.

7. Verwendung nach Anspruch 6, **dadurch gekennzeichnet, dass** die Pigmentzubereitung 5 bis 30 Gew.-% an Pigmentdispergator der Formel (II) oder (III), bezogen auf das Gewicht des Basispigments der Formel (I), enthält.

8. Verwendung nach mindestens einem der Ansprüche 1 bis 7, **dadurch gekennzeichnet, dass** die Pigmentzubereitung mit einem Farbmittel aus der Gruppe der organischen oder anorganischen Pigmente oder der organischen Farbstoffe nuanciert ist.

## Claims

1. The use of a pigment preparation comprising
a) a dioxazine compound of the formula (I) as base pigment 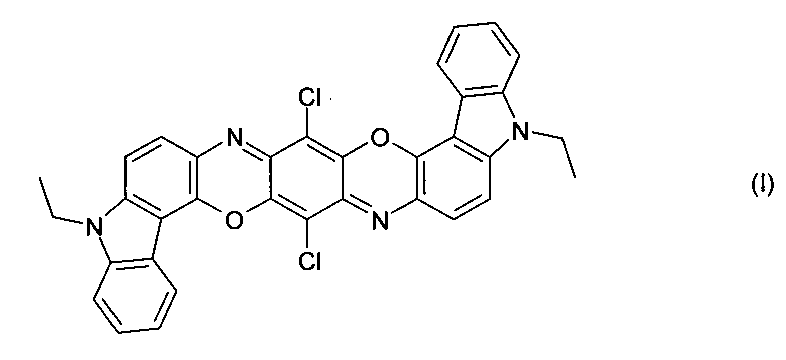 and
b) a dioxazine compound of the formula (II) as pigment dispersant
Q-[Y-X]ₘ (II)
in which
Q is an m-valent radical of the base pigment of the formula (I),
Y is a bridging moiety from the series -(CR¹R²)ₓ- with x being 1 to 6, substituted or unsubstituted phenylene, -CO-, or -NR³-, or a nonrepeating or repeating combination of at least two such bridging members of different type, R¹, R², and R³ independently of one another being hydrogen or C₁-C₄-alkyl,
X is the radical of an aliphatic or aromatic, five-, six- or seven-membered heterocyclic system which is attached to the bridging member Y via a C atom and has in each case 1 to 3 identical or different ring heteroatoms from the series nitrogen, oxygen or sulfur and if desired also has a benzo-fused ring and may be substituted by C₁-C₄-alkyl, C₂-C₄-alkenyl, C₁-C₃-hydroxyalkyl or phenyl;
or is a phthalimido radical which is attached to the bridging member Y via the imide nitrogen and which may be substituted up to a maximum of four times on the benzoid ring by chloro, bromo, nitro, carboxyl, N-(C₁-C₅-alkyl)carbamoyl, N-phenylcarbamoyl or benzoylamino;
or is a radical -NR⁴R⁵, in which R⁴ and R⁵ independently of one another are each hydrogen, substituted or unsubstituted C₁-C₂₀-alkyl or C₂-C₂₀-alkenyl, C₅-C₆-cycloalkyl, substituted or unsubstituted phenyl, benzyl or naphthyl;
or in which the group -NR⁴R⁵ forms an aliphatic or aromatic, five-, six- or seven-membered heterocyclic system having in each case 1 to 3 identical or different ring heteroatoms from the series nitrogen, oxygen or sulfur, which if desired also has a benzo-fused ring and may be substituted by hydroxyl, oxo, C₁-C₄-alkyl, C₂-C₄-alkenyl, C₁-C₃-hydroxyalkyl or phenyl, and
m indicates a numerical value between 1 and 4,
as a colorant in colour filters, ink-jet inks, electrophotographic toners and developers, and electronic inks.

2. The use as claimed in claim 1, wherein
Y has the definition -(CH₂)ₚ-, -CO-NR³-(CH₂)ₚ-, -CH₂-NR³-CO-(CH₂)ₚ- or -CH₂-NR³-CO-CH₂-NH-(CH₂)ₙ-, in which R³ is hydrogen or C₁-C₄-alkyl, and n and p independently of one another are each numerical values from 1 to 6,
X is the radical of a furan, thiophene, pyrrole, pyrazole, thiazole, oxazole, triazole, imidazole, thionaphthene, benzoxazole, benzothiazole, benzimidazole, benzotriazole or indole which is attached to the bridging member Y via a C atom;
or is a radical -NR⁴R⁵, in which R⁴ and R⁵ independently of one another are each hydrogen, unsubstituted or substituted C₁-C₆-alkyl or C₂-C₆-alkenyl, C₅-C₆-cycloalkyl, unsubstituted or substituted phenyl, benzyl or naphthyl;
or in which the group -NR⁴R⁵ is a pyrrolinyl, pyrrolidinyl, piperidinyl, morpholinyl, homopiperidinyl or imidazolyl which if desired also has a benzo-fused ring and may be substituted by hydroxyl, oxo, C₁-C₄-alkyl, C₁-C₃-hydroxyalkyl or phenyl, and
m is a number from 1 to 3.

3. The use as claimed in claim 1 or 2, wherein
Y is -(CH₂)₁₋₃-, -CO-NH-(CH₂)₁₋₃-, -CH₂-NH-CO-(CH₂)₁₋₃- or -CH₂-NH-CO-CH₂-NH-(CH₂)₂₋₃-,
X is imidazolyl which is attached to the bridging member Y via the imide nitrogen or the positions 4 or 5, or is a radical -NR⁴R⁵, R⁴ and R⁵ being hydrogen or C₁-C₄-alkyl, and
m is a number from 1 to 2.5.

4. The use as claimed in at least one of claims 1 to 3, wherein the pigment dispersant is a compound of the formula (III) 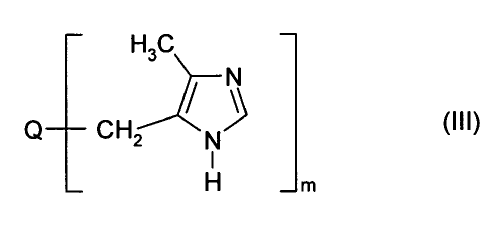 in which
m stands for a numerical value from 1 to 4.

5. The use as claimed in claim 4, wherein m is a number from 1 to 2.

6. The use as claimed in at least one of claims 1 to 5, wherein the pigment preparation contains 0.5% to 99% by weight of pigment dispersant of the formula (II) or (III), based on the weight of the base pigment of the formula (I).

7. The use as claimed in claim 6, wherein the pigment preparation contains 5% to 30% by weight of pigment dispersant of the formula (II) or (III), based on the weight of the base pigment of the formula (I).

8. The use as claimed in at least one of claims 1 to 7, wherein the pigment preparation is shaded with a colorant from the group of organic or inorganic pigments or of organic dyes.

## Revendications

1. Utilisation d'une préparation pigmentaire, **caractérisée par** une teneur
a) en un composé dioxazine de formule (I) comme pigment de base 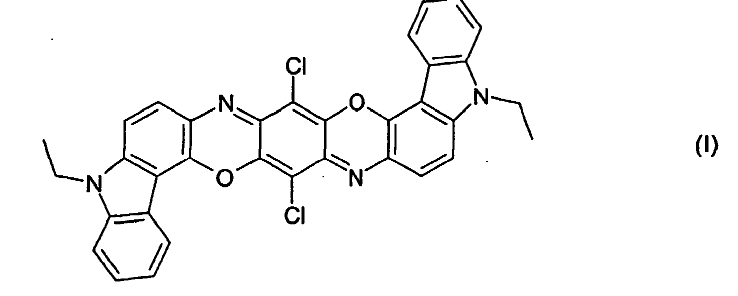 et
b) en un composé dioxazine de formule générale (II) comme dispersant de pigment
Q- [Y-X]ₘ (II)
où
Q représente un radical m-valent du pigment de base
de formule (I),
Y désigne un groupement formant un pont de la série -(CR¹R²)ₓ- avec x valant 1 à 6, phénylène substitué ou non substitué, -CO-, ou -NR³- ou une combinaison le cas échéant répétitive d'au moins deux de ces éléments de pont de type différent, où R¹, R² et R³ signifient, indépendamment l'un de l'autre, hydrogène ou C₁-C₄-alkyle,
X représente le radical d'un système, lié via un atome de C à l'élément de pont Y, hétérocyclique de cinq, six ou sept chaînons, aliphatique ou aromatique, comprenant à chaque fois 1 à 3 hétéroatomes de cycle identiques ou différents de la série azote, oxygène ou soufre, qui présente le cas échéant encore un cycle benzocondensé et qui peut être substitué par C₁-C₄-alkyle, C₂-C₄-alcényle, C₁-C₃-hydroxyalkyle ou phényle ;
- ou un radical phtalimido lié via l'azote de fonction imide à l'élément de pont Y, qui peut être au maximum tétrasubstitué sur le cycle benzénique par chlore, brome, nitro, carboxy, N-(C₁-C₅-alkyl)-carbamoyle, N-phénylcarbamoyle ou benzoylamino ;
- ou représente un radical -NR⁴R⁵, dans lequel R⁴ et R⁵ représentent, indépendamment l'un de l'autre, à chaque fois hydrogène, C₁-C₂₀-alkyle ou C₂-C₂₀-alcényle substitués ou non substitués, C₅-C₆-cycloalkyle, phényle, benzyle ou naphtyle substitués ou non substitués ;
- ou en ce que le groupe -NR⁴R⁵ représente un système aliphatique ou aromatique, hétérocyclique à cinq, six ou sept chaînons comprenant à chaque fois 1 à 3 hétéroatomes de cycle identiques ou différents de la série azote, oxygène ou soufre, qui présente le cas échéant encore un cycle benzocondensé et qui peut être substitué par hydroxy, oxo, C₁-C₄-alkyle, C₂-C₄-alcényle, C₁-C₃-hydroxyalkyle ou phényle, et
m vaut une valeur numérique entre 1 et 4,
comme colorant dans des filtres couleur, des encres à jet d'encre, des toners et révélateurs électrophotographiques et des encres électroniques.

2. Utilisation selon la revendication 1, **caractérisée en ce que**
Y signifie -(CH₂)ₚ-, -CO-NR₃- (CH₂)ₚ-, -CH₂-NR³-CO-(CH₂)ₚ- ou -CH₂-NR³-CO-CH₂-NH-(CH₂)ₙ-, où R³ signifie hydrogène ou C₁-C₄-alkyle, et n et p représentent, indépendamment l'un de l'autre, à chaque fois des valeurs numériques de 1 à 6,
X signifie le radical d'un furanne, thiophène, pyrrole, pyrazole, thiazole, oxazole, triazole, imidazole, thionaphtène, benzoxazole, benzothiazole, benzimidazole, benzotriazole ou indole lié via un atome de C à l'élément de pont Y ;
- ou représente un radical -NR⁴R⁵, dans lequel R⁴ et R⁵ représentent, indépendamment l'un de l'autre, à chaque fois hydrogène, C₁-C₆-alkyle ou C₂-C₆-alcényle le cas échéant substitués, C₅-C₆-cycloalkyle, phényle, benzyle ou naphtyle le cas échéant substitués ;
- ou **en ce que** le groupe -NR⁴R⁵ signifie pyrrolinyle, pyrrolidinyle, pipéridinyle, morpholinyle, homopipéridinyle ou imidazolyle, qui présente le cas échéant encore un cycle benzocondensé et qui peut être substitué par hydroxy, oxo, C₁-C₄-alkyle, C₁-C₃-hydroxyalkyle ou phényle et
m représente un nombre de 1 à 3.

3. Utilisation selon la revendication 1 ou 2, **caractérisée en ce que**
Y représente - (CH₂)₁₋₃-, -CO-NH-(CH₂)₁₋₃-, -CH₂-NH-CO-(CH₂)₁₋₃- ou -CH₂-NH-CO-CH₂-NH-(CH₂)₂-₃-,
X désigne imidazolyle lié via l'azote de la fonction imide ou les positions 4 ou 5 à l'élément de pont Y ou un radical -NR⁴R⁵, où R⁴ et R⁵ représentent hydrogène ou C₁-C₄-alkyle, et
m représente un nombre de 1 à 2,5.

4. Utilisation selon au moins l'une quelconque des revendications 1 à 3, **caractérisée en ce que** le dispersant de pigment est un composé de formule (III) 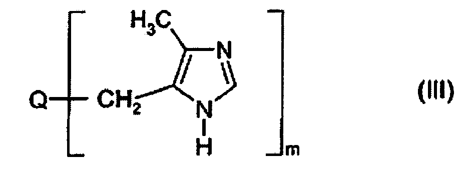 où
m représente une valeur numérique de 1 à 4.

5. Utilisation selon la revendication 4, **caractérisée en ce que** m représente un nombre de 1 à 2.

6. Utilisation selon au moins l'une quelconque des revendications 1 à 5, **caractérisée en ce que** la préparation pigmentaire contient 0,5 à 99% en poids de dispersant de pigment de formule (II) ou (III), par rapport au poids du pigment de base de formule (I).

7. Utilisation selon la revendication 6, **caractérisée en ce que** la préparation pigmentaire contient 5 à 30% en poids de dispersant de pigment de formule (II) ou (III), par rapport au poids du pigment de base de formule (I).

8. Utilisation selon au moins l'une quelconque des revendications 1 à 7, **caractérisée en ce que** la préparation pigmentaire est nuancée avec un colorant du groupe des pigments organiques ou inorganiques ou des colorants organiques.
